(19) Europäisches Patentamt
European Patent Office
Office européen des brevets

(11) **EP 2 383 809 A1**

(12) **EUROPEAN PATENT APPLICATION**
published in accordance with Art. 153(4) EPC

(43) Date of publication:
**02.11.2011 Bulletin 2011/44**

(51) Int Cl.:
*H01L 35/30* (2006.01)    *H02N 11/00* (2006.01)

(21) Application number: **10733326.2**

(22) Date of filing: **14.01.2010**

(86) International application number:
**PCT/JP2010/000185**

(87) International publication number:
**WO 2010/084718 (29.07.2010 Gazette 2010/30)**

(84) Designated Contracting States:
**AT BE BG CH CY CZ DE DK EE ES FI FR GB GR HR HU IE IS IT LI LT LU LV MC MK MT NL NO PL PT RO SE SI SK SM TR**

(30) Priority: **21.01.2009 JP 2009011006**

(71) Applicant: **Central Research Institute of Electric Power Industry Chiyoda-ku Tokyo 1008126 (JP)**

(72) Inventor: **KAMBE, Mitsuru Komae-shi Tokyo 201-8511 (JP)**

(74) Representative: **Henkel, Breuer & Partner Patentanwälte Maximiliansplatz 21 80333 München (DE)**

(54) **PACKAGED THERMOELECTRIC CONVERSION MODULE**

(57)    A packaged thermoelectric conversion module that does not need a pressing mechanism for reducing a thermal contact resistance or an application of a thermal-conductive grease between a heat source of a thermoelectric conversion module sealed in an airtight container, wherein an interior of an airtight container 13 containing a thermoelectric conversion module 5 is decompressed or evacuated, wherein the interior of the airtight container 13 is partitioned into two chambers 14 and 17 by a partition plate 7, wherein one chamber 17 is provided with the thermoelectric conversion module 5 and electrodes 9a and 9b led out to the outside of the airtight container 13, while the other chamber 14 is provided with a flow path 16 for introducing a thermal medium 26 or 25 from an external thermal medium supplying source and circulating the thermal medium 26 or 25 between the chamber 14 and the external thermal medium supply source, and heat is transferred to or received from one surface of the thermoelectric semiconductor 2 by the thermal medium 26 or 25 via the partition plate 7, while heat is transferred or received between the other surface of the thermoelectric semiconductor 2 and an external heat source via the airtight container 13.

Fig.2

**Description**

TECHNICAL FIELD

The present invention relates to a thermoelectric conversion module that generates electricity by utilizing a difference of a temperature applied to a thermoelectric semiconductor. More specifically, the present invention relates to an improvement of a packaged thermoelectric conversion module contained in an airtight container in order to realize a large-sized thermoelectric conversion module.

BACKGROUND ART

In a thermoelectric conversion module having a general structure of a conventional mass-production scale, electrodes are arranged on upper and lower surfaces of plural pairs of thermoelectric semiconductors so as to form an electric circuit, wherein a plate having electrically insulating property, such as a ceramic plate or a metallic plate having an electrical insulating film, is arranged at the outside of the respective electrodes so as to sandwich the electrodes, and they are bonded with a bonding member such as a bonding agent or brazing filler metal, whereby the thermoelectric conversion module is assembled.

However, this structure makes it difficult to increase the size of the thermoelectric conversion module. A thermoelectric conversion module having a planar size of about 4 cm x 4 cm is general, and the greatest one has a planar size of about 6 cm x 6 cm. A thermoelectric conversion module having a size larger than that described above is difficult to be realized, because shearing force caused by a thermal expansion of a heating plate sandwiching the thermoelectric semiconductor might break a fragile thermoelectric semiconductor, or the respective members might be peeled on the bonding surface. This problem is particularly significant in a high-temperature thermoelectric conversion module having an operating temperature of 500°C or higher, which module is supposed to use a waste heat from industrial facilities involved with heat, such as a vehicle or an industrial furnace, as a heat source.

On the other hand, it is necessary to increase a packing density of a thermoelectric semiconductor in order to increase an output per unit area in a thermoelectric conversion system provided with plural thermoelectric conversion modules. In order to increase the packing density, it is desired that the size of the thermoelectric conversion module be increased as much as possible. However, another problem involves with the increase in size as described above, so that increasing size is difficult. Reducing heat resistance is important to increase the output of the thermoelectric conversion module. However, when the thermoelectric semiconductor is strongly sandwiched between a heating plate and a cooling plate for attaining an intimate contact between the respective components of the thermoelectric module, the weak thermoelectric semiconductor might be crushed. Therefore, it is difficult to reduce heat resistance.

When a thermoelectric conversion module is placed in an oxidation atmosphere such as in high-temperature air, or in a corrosive atmosphere such as in combustion gas in a garbage incinerator, a thermoelectric conversion module having a thermoelectric semiconductor or an electrode portion exposed to ambient air might be oxidized or might be corrosive. A conventional thermoelectric conversion module cannot be placed as being exposed to the atmosphere described above. Therefore, a method of indirectly heating the thermoelectric conversion module is generally used, wherein the high-temperature gas is isolated by a duct or a partition wall. However, the system described above not only needs a structure such as a duct or a partition wall, but also has a drawback of deteriorating power generating property of the thermoelectric conversion module by an amount corresponding to the reduction in the difference in the temperature applied to the thermoelectric semiconductor due to the indirect heating.

In view of this, the present inventor has proposed a thermoelectric conversion module contained in an airtight container (Patent Document 1). In the thermoelectric conversion module contained in the airtight container, plural pairs of thermoelectric semiconductors are contained in the airtight container, wherein a heat-source-side electrode portion that electrically connects the thermoelectric semiconductors in series is provided on the surface of the thermoelectric semiconductor at the side of a high-temperature heat source, while a discharge-side electrode portion that electrically connects the thermoelectric semiconductors in series is provided on the surface of the thermoelectric semiconductor at the side of a low-temperature heat source, and the interior of the case is decompressed or evacuated. The airtight container includes a heating plate that covers the heat-source-side electrode portion and receives heat from the high-temperature heat source, a cooling plate that covers the discharge-side electrode portion and transmits heat to the low-temperature heat source, and a connection plate that connects the cooling plate and the heating plate and sandwiches the thermoelectric semiconductors and the electrode portions between the cooling plate and the heating plate through a sliding member so as to combine them. The sliding member having thermal conductivity is interposed between at least the heat-source-side electrode portion and the heating plate in the airtight container so as to allow the relative sliding movement between them in a pressurized state. The sliding member is pressed against the heat-source-side electrode portion by the pressing force applied between the heating plate and the cooling plate, thereby being held together with the heat-source-side electrode portion.

Citation List

Patent Document

Patent Document 1: Japanese Patent Application Laid-Open No. 2006-49872

DISCLOSURE OF INVENTION

PROBLEM TO BE SOLVED BY THE INVENTION

However, even a conventional thermoelectric conversion module contained in an airtight container has a problem that it needs a pressing mechanism for reducing thermal contact resistance. Specifically, even when it is heated by a radiation from the high-temperature heat source, it is necessary to be in pressed contact with a cooling duct in order to reduce a thermal contact resistance. The output of the thermoelectric conversion module is roughly in proportion to the square of the temperature difference of the thermoelectric semiconductor. Therefore, when the thermal contact resistance is large, the temperature difference applied to the thermoelectric semiconductor is reduced, whereby the output of the thermoelectric conversion module is greatly reduced.

It is necessary to enhance flatness of the contact surface and precision in surface finish, and to strongly press the surface, in order to reduce the thermal contact resistance. However, enhancing the flatness and precision in surface finish increases cost. Maintaining a predetermined pressing force regardless of the operating temperature needs a complicated mechanism, which also increases cost.

It is also considered that a viscous thermal-conductive material such as a thermal-conductive grease is applied on the contact interface between the cooling duct and the airtight container in order to reduce the thermal contact resistance. However, the grease exposed to ambient air is deteriorated in a short period. Therefore, it is necessary to frequently disassemble the apparatus to again apply the grease thereon, so that this method is unsuitable for a practical system. From the above, a cheap and high-performance thermoelectric conversion module and system have currently been demanded that can solve the above-mentioned problem of the thermal contact resistance.

The present invention aims to provide a thermoelectric conversion module that has a simplified pressing mechanism for reducing the thermal contact resistance, or does not need at all the pressing mechanism, or that does not need an application of the viscous thermal-conductive material such as a thermal-conductive grease on the contact interface between the duct and the airtight container.

MEANS FOR SOLVING PROBLEM

In order to attain the foregoing object, the present invention provides a packaged thermoelectric conversion module in which an interior of an airtight container containing a thermoelectric conversion module is decompressed or evacuated, wherein the interior of the airtight container is partitioned into at least two chambers by a partition plate, wherein one chamber is provided with a thermoelectric conversion module and an electrode led out to the outside of the airtight container, while the other chamber is provided with a flow path for introducing a thermal medium from an external thermal medium supplying source and circulating the thermal medium between the chamber and the external thermal medium supplying source, and heat is transferred or received to or from one surface of a thermoelectric semiconductor by the thermal medium via the partition plate, while heat is transferred and received between the other surface of the thermoelectric semiconductor and an external heat source via the airtight container.

Accordingly, in the packaged thermoelectric conversion module according to the present invention, the partition plate in the airtight container is directly cooled or heated by the thermal medium circulating between the chamber and the external thermal medium supplying source. On the other hand, the surrounding of the thermoelectric semiconductor is decompressed or evacuated. Therefore, the thermoelectric semiconductor is brought into intimate contact with the partition plate due to the differential pressure between the inside and the outside of the airtight container, and is always pressed, whereby the thermal contact resistance is reduced. The contact interface between the upper case of the airtight container and the thermoelectric semiconductor is also pressed, whereby the thermal contact resistance is reduced.

It is preferable that at least the surface of the airtight container that is in contact with the other surface of the thermoelectric semiconductor, i.e., the surface of the airtight container that is in contact with the surface of the thermoelectric semiconductor opposite to the chamber for circulating the thermal medium, is made of a thermal-conductive material having flexibility. It is also preferable that the airtight container includes an upper case and a lower case, wherein the thermal medium circulating chamber is formed by a gate provided at the bottom part of the lower case, while the partition plate is fitted to be bonded to a striker plate formed on the top surface of the gate enclosing the thermal medium circulating chamber so as to form a liquid-tight flow path between the partition plate and the lower case. It is also preferable that the flow path is a single heavily winding groove that rises from the bottom surface of the lower case toward the partition plate, and that is formed by plural partition walls alternately projecting from one side to the other side of the opposing gate, wherein an inlet pipe and an outlet pipe serving as an inlet and an outlet of the thermal medium are connected to both ends of the flow path. It is also preferable that the thermoelectric conversion module is supported by a thermoelectric conversion module substrate having electrical insulating property, and is mounted on the partition plate via the substrate. It is also preferable that the thermoelectric conversion module is a two-sided skeleton module having no substrate on upper and lower surfaces. It is also preferable that the thermal medium is a cooling fluid or a heating fluid.

EFFECT OF THE INVENTION

According to the packaged thermoelectric conversion module of the present invention, the contact interface of both surfaces of the thermoelectric conversion module are satisfactorily in intimate contact due to pressing force caused by the differential pressure between the inside and the outside of the airtight container, whereby the thermal contact resistance at the contact interface can be reduced. Specifically, the thermoelectric conversion module in the case and the partition plate serving as the cooling or heating panel and the upper case serving as the heating or cooling panel are pressed against each other by the differential pressure between the inside and the outside of the case, whereby the thermal contact resistance can be reduced, and a large temperature difference can be applied to the thermoelectric semiconductor.

One thermal medium for applying the temperature difference to the thermoelectric conversion module circulates in the airtight container, whereby the heat of the thermal medium can stably be applied to the thermoelectric conversion module. Therefore, one of the surfaces of the thermoelectric semiconductor is heated or cooled by a radiation heat transfer from a radiant heat source opposite to the packaged thermoelectric conversion module or convection heat transfer by the thermal medium flowing around the packaged thermoelectric conversion module, and the other surface of the thermoelectric semiconductor is cooled or heated by the cooling fluid or the heating fluid flowing through the flow path in the airtight container via the partition plate, whereby the mechanism for pressed contact or an application of a viscous thermal-conductive material such as a thermal-conductive grease between the airtight container and the duct introducing the thermal medium are not required. Even when a duct for flowing a heating fluid or a cooling fluid is in pressed contact with one surface of the thermoelectric semiconductor, i.e., one surface of the airtight container, so as to transfer or receive heat, the duct is only pressed against one surface of the airtight container of the packaged thermoelectric conversion module, with the result that the pressing mechanism can be simplified. Accordingly, restriction is not imposed on the usage of the packaged thermoelectric conversion module according to the present invention. Therefore, the packaged thermoelectric conversion module can be used only by arranging the same under any environment, such as under the radiation heat from a high-temperature heat source, for example, under the environment in which waste heat radiated from a heated component generated in an industrial furnace such as a powdered metallic ceramic sintering furnace or various electric furnaces is used as a heat source of a radiation heat transfer, under the environment in which waste gas or high-temperature fluid such as waste liquid discharged from various industrial facilities involved with heat, such as an industrial waste sintering furnace is used as a heat source of convection heat transfer, or under the environment in which heat obtained with a thermal conduction through a contact to a solid heat source is used as a heat source.

In the packaged thermoelectric conversion module according to the present invention, the components of the thermoelectric conversion module are sealed in the airtight container. Therefore, the deterioration of the components, contained in the container, of the thermoelectric conversion module due to the oxidation can be prevented without being affected by ambient air. Further, since the components of the thermoelectric conversion module are contained in the airtight container, external physical shock or a rapid change in an external atmosphere such as external pressure or temperature are eased, and the strength to the external force is increased.

When the surface of the airtight container that is in contact with at least the other surface of the thermoelectric semiconductor, i,e., with the surface of the thermoelectric semiconductor opposite to the chamber for circulating the thermal medium, is made of a thermal-conductive material having flexibility, the surface opposite to the thermoelectric conversion module is deformed due to the differential pressure between the inside and the outside of the container, and is pressed against the thermoelectric conversion module to be in intimate contact therewith, whereby the heat resistance can be reduced.

When the airtight container includes the upper case and the lower case, wherein the thermal medium circulating chamber is formed by a gate provided at the bottom part of the lower case, while the partition plate is fitted to be bonded to a striker plate formed on the top surface of the gate enclosing the thermal medium circulating chamber so as to form a liquid-tight flow path between the partition plate and the lower case, the thermal medium flows in the airtight container without leakage, whereby one surface of the thermoelectric conversion module is cooled or heated.

When the flow path is configured by a single heavily winding groove in order to allow the thermal medium to flow therein, the thermal medium uniformly flows, whereby the heat can efficiently be applied to one surface of the thermoelectric conversion module.

According to the thermoelectric conversion module of the present invention, either one of a cooling fluid or a heating fluid is flown into the flow path in the airtight container as the thermal medium. Therefore, only by arranging the packaged thermoelectric conversion module under any environment, a temperature difference is applied to the thermoelectric conversion module so as to generate electricity.

BRIEF DESCRIPTION OF DRAWINGS

FIG. 1 is a bottom view illustrating one embodiment of a thermoelectric conversion module according to the present invention.

FIG. 2 is a longitudinal sectional view taken along a line II - II in FIG. 1..

FIG. 3 is a longitudinal sectional view taken along a line III - III in FIG. 1.

FIG. 4 is a longitudinal sectional view taken along a line IV - IV in FIG. 1.

FIG. 5 is a perspective view illustrating an appearance of a lower case constituting an airtight container viewed from the bottom.

FIG, 6 is a perspective view illustrating the interior of the lower case as viewed from the top, wherein (A) mainly illustrates a flow path of a thermal medium, and (B) illustrates a relationship between the flow path of the thermal medium and an electrode groove.

FIG. 7 is a longitudinal sectional view illustrating one of examples of use of the packaged thermoelectric conversion module according to the present invention, wherein a cooling fluid is circulated in the container and the module is heated by a radiant heat source.

FIG. 8 is a longitudinal sectional view illustrating another example of use of the packaged thermoelectric conversion module according to the present invention, wherein the cooling fluid is circulated in the container, and a heating fluid is flown at the outside of the top surface (the surface with which the module is in contact) of the case for heating.

FIG. 9 is a longitudinal sectional view illustrating another example of use of the packaged thermoelectric conversion module according to the present invention, wherein the heating fluid is circulated in the container, and the cooling fluid is flown to the outside of the top surface of the case for cooling.

FIG. 10 is a longitudinal sectional view illustrating another example of use of the packaged thermoelectric conversion module according to the present invention, wherein the cooling fluid is circulated in the container, and a heating duct for flowing the heating fluid to the outside of the top surface of the case is arranged for heating.

FIG. 11 is a longitudinal sectional view illustrating another example of use of the packaged thermoelectric conversion module according to the present invention, wherein the heating fluid is circulated in the container, and a cooling duct for flowing the cooling fluid to the outside of the top surface of the case is arranged for cooling.

FIG. 12 is a schematic view illustrating a configuration of a packaged thermoelectric conversion module containing nine thermoelectric conversion modules in a single airtight container, wherein (A) is a plan view, and (B) is a central longitudinal sectional view.

FIG. 13 is a perspective view illustrating a thermoelectric conversion module in an exposed state that is used for comparison in an experiment for confirming a performance of the packaged thermoelectric conversion module according to the present invention.

FIG. 14 is a graph illustrating a measurement result of an output of the thermoelectric conversion module in an exposed state illustrated in FIG. 13.

FIG. 15 is a graph illustrating a measurement result of an output when the packaged thermoelectric conversion module of the present invention is configured to contain the module illustrated in FIG. 13 in an airtight container.

BEST MODE FOR CARRYING OUT THE INVENTION

A configuration of the present invention will be described below with reference to the embodiment illustrated in the drawings.

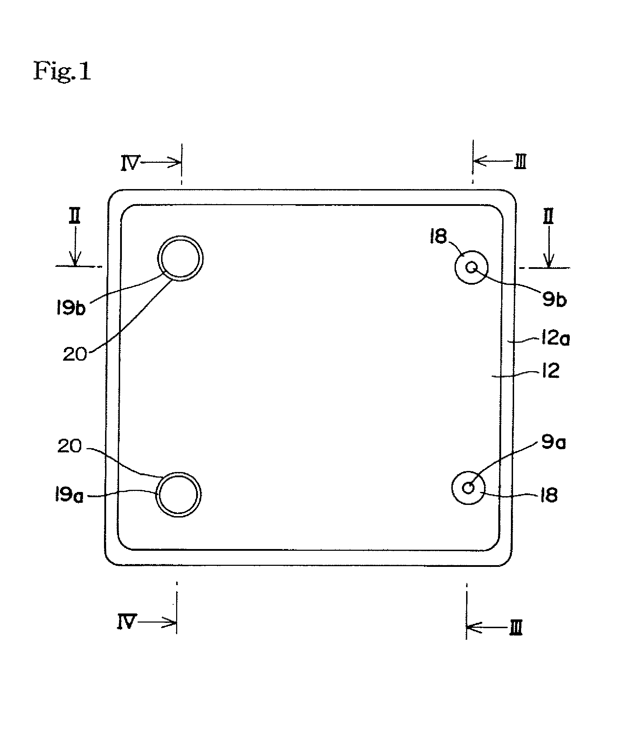

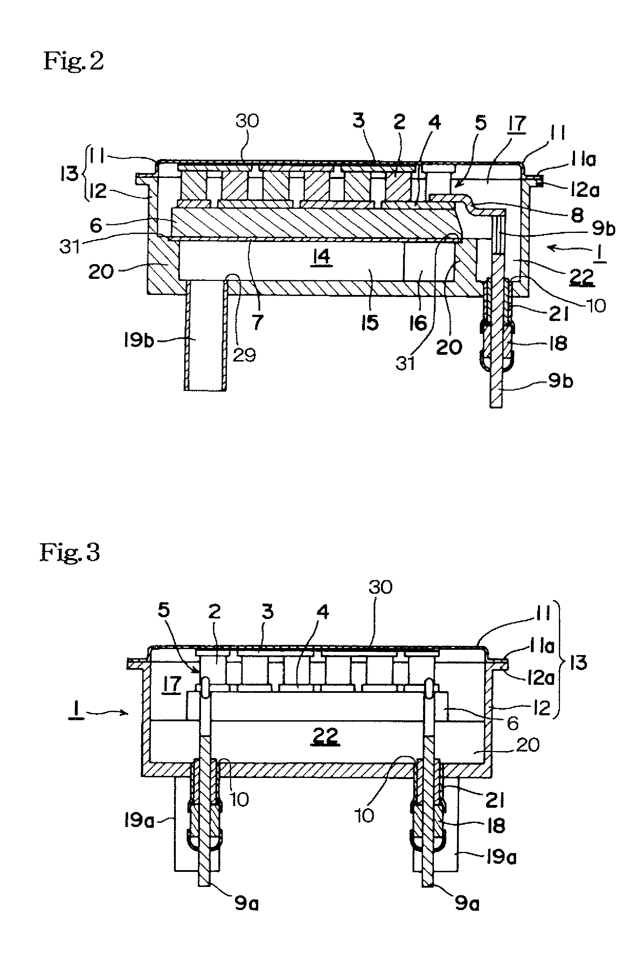

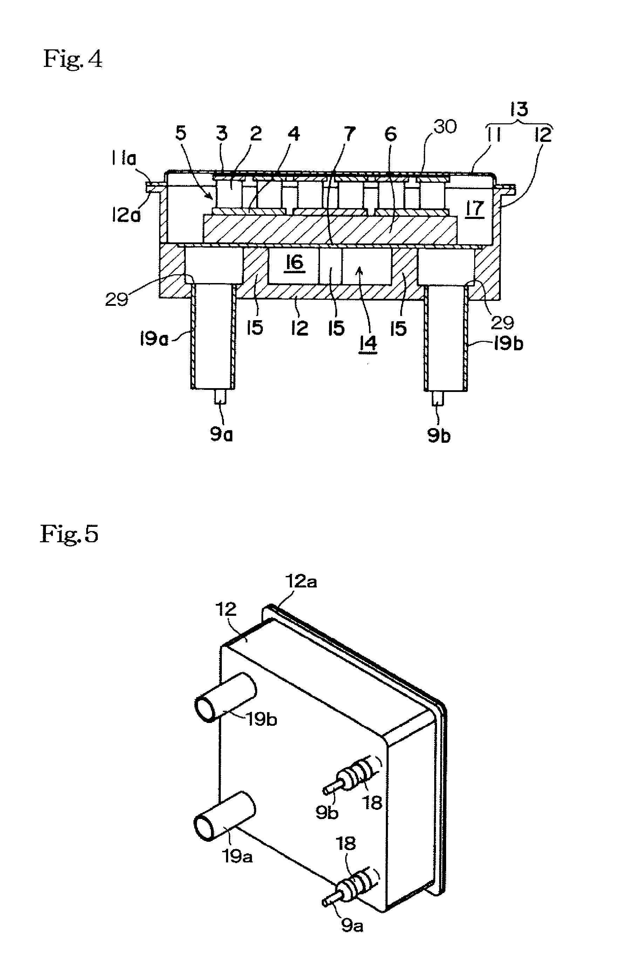

FIGS. 1 to 4 illustrate one embodiment of a thermoelectric conversion module according to the present invention. A packaged thermoelectric conversion module 1 is configured such that a module 5 of a thermoelectric semiconductor 2 is sealed in a container having airtightness (hereinafter referred to as an airtight container) 13, and the interior thereof is decompressed or evacuated. The thermoelectric conversion module 5 generally includes at least a pair of thermoelectric semiconductors 2, and one electrode 3 and the other electrode 4 electrically connected to the thermoelectric semiconductors 2, wherein the respective electrodes 3 and 4 are connected in series so as to form an electric circuit in which there is an electrical connection between a lead wire 8 at an end and a pair of electrodes 9a and 9b. The pair of electrodes 9a and 9b are formed to extend to the outside of the airtight container 13 from one corner of the container 13, wherein an electrical insulating member 18 and an airtight seal 21 are interposed between an electrode leading hole 10 of the airtight container 13 and each of the electrodes 9a and 9b. With this structure, power generated by the thermoelectric conversion module 5 can be taken out to the outside of the container 13, while keeping airtightness of the airtight container 13. The power generated by the thermoelectric conversion module 5 is supplied to an electric storage device or a power-using device through a power collecting line not illustrated.

In the present embodiment, the airtight container 13 includes a flanged upper case 11 and a flanged lower case 12. After the thermoelectric conversion module 5 and the incidental equipment such as the electrodes 9a and 9b are accommodated, opposing flanges 11a and 12a of the upper case 11 and the lower case 12 are bonded with an electron beam welding under vacuum atmosphere so as to be combined with the interior being decompressed or evacuated. Specifically, the interior of the airtight container 13 is partitioned into at least two chambers, which are a thermoelectric conversion module storing chamber 17 and a thermal medium circulating chamber 14, with a partition plate 7. The thermoelectric conversion module 5 is stored in the thermoelectric conversion module storing chamber 17, and a differential pressure is caused between the airtight container 13 and the outside of the container by decompression or vacuuming. The surface of the upper case 11 opposing the thermoelectric conversion module 5 corresponds to a heat receiving plate that transfers heat to one surface of the thermoelectric conversion module 5. The bonding of the flanges 11a and 12a is not limited to the electron beam welding. They can be bonded with another welding method, or with a brazing filler metal or an adhesive agent, suitable for the material of the case. The upper case 11 and the lower case 12, which directly oppose to each other, may be bonded without forming the flanges 11a and 12a.

It is preferable that the pressure in the interior of the airtight container 13, i.e., in the thermoelectric conversion module storing chamber 17, is under a decompression atmosphere or in a vacuum by which a differential pressure of at least 0.4 atmospheric pressure or higher can be obtained during the operation, supposing that the pressure in the interior of the airtight container 13, i.e., in the thermoelectric conversion module storing chamber 17 is set to be lower than the pressure at the outside of the airtight container 13. Due to the presence of the differential pressure, the thermoelectric conversion module 5 is pressed and brought into intimate contact with upper case 11 and the partition plate 7 at the contact interface between the thermoelectric conversion module 5 and the upper case 11 and the contact interface between the thermoelectric conversion module 5 and the partition plate 7 because of the pressing force externally applied to the airtight container 13, whereby the thermal contact resistance is reduced. According to the experiment conducted by the present inventor (see Patent Document 1), for example, when it is supposed that a packaged thermoelectric conversion module 1. is operated at 550°C under atmospheric pressure, and a charged pressure ($P_{RT}$) at room temperature (27°C) is -0.8 atmospheric pressure (gauge pressure), an internal pressure $P_{550}$ when heated to 550°C is 0.55 atmospheric pressure in an absolute pressure and - 0.45 atmospheric pressure in the gauge pressure, which indicates that sufficient pressure for applying sufficient temperature difference can be applied. In this case, the pressure for pressing the container 7 from the outside is 0.45 kg/cm$^2$= 4.5 ton/m$^2$.

It is preferable that the surface of the airtight container 13 opposing to at least the thermoelectric conversion module 5 (the other surface of the thermoelectric semiconductor 2) is made of a thermal conductive material having flexibility to a degree in which the surface is pressed against the thermoelectric conversion module 5 because of the reformation caused by the differential pressure between the inside and the outside of the container, and a rigidity to a degree in which the surface is not destroyed by the differential pressure and the airtightness can be secured. In the present embodiment, the upper case 11 is made of a thin plate of a material excellent in thermal conductivity. For example, when BiTe is used as the thermoelectric semiconductor 2 to form a low-temperature thermoelectric conversion module 1, the heated side of the airtight container 13, i.e., the upper case 11, has a temperature of 250°C or lower, for example. Therefore, examples of the usable material for the upper case 11 include aluminum (Al), copper (Cu), or stainless steel (e.g., SUS304, SUS316). For example, when FeSi is used as the thermoelectric semiconductor 2 to form a high-temperature thermoelectric conversion module 1, the heated side of the airtight container 13, i.e., the upper case 11, has a temperature of about 600°C. Therefore, a heat-resistant steel such as Inconel (registered trademark of Special Metals Corporation), for example, can be used as the material of the upper case 11. Of course, a material that can be used according to an environment of use may be selected. The number of the thermoelectric conversion module 5 that can be stored in one airtight container 13 is not limited, but the airtight container 13 has desirably a substantial square shape in order to equally bring the upper case 11 into intimate contact with the respective modules 5.

The material of the upper case 11 is not limited to the exemplified materials described above, and not always limited to metal. The material of the upper case 11 may appropriately be selected from the viewpoint of heat-resistance property, corrosion resistance, and workability. It is not limited that the monolithic upper case 11 is formed with a press molding. For example, in the case of a material that is difficult to be subject to spinning with a press molding, the portion of the top surface of the upper case 11 opposing to the thermoelectric conversion module 5 and a surrounding curvature portion (a part of a connection plate) may be processed from a single plate with a press molding, and the other side face, i.e., the other connection plate may be prepared integrally with a cooling plate or prepared from another member (metal or ceramic). They may be assembled by a welding or a bonding method using a brazing filler metal or an adhesive agent to complete the airtight container 13.

The thermal medium circulating chamber 14 formed with a flow path 16 in which a thermal medium flows, and an electrode groove 22 in which the electrodes 9a and 9b for leading the electrodes 3 and 4 of the thermoelectric conversion module 5 out of the container are arranged, are provided at the inside of the lower case 12. The thermal medium circulating chamber 14 and the electrode groove 22 is divided by a gate 20. The partition plate 7 is covered so as to be placed on the top surface of the gate 20 surrounding the thermal medium circulating chamber 14, whereby the flow path 16 in which the thermal medium uniformly flows is formed only at a part of the lower case 12, i.e., only the part below the portion where the thermoelectric conversion module 5 is arranged. The partition plate 7 is fitted to be bonded to a striker plate 31 formed on the top surface of the gate 20 with a step, thereby forming a liquid-tight flow path 16 between the partition plate 7 and the lower case 12. In this case, the surrounding of the partition plate 7 is supported by the striker plate 31, and the interior thereof is supported by plural partition walls 15. Thus, the partition plate 7 is directly cooled or heated by a cooling fluid or a heating fluid supplied from an external thermal medium supplying source, not illustrated, whereby heat can efficiently be transferred to one surface of the thermoelectric conversion module 5 via a thermoelectric conversion module substrate (hereinafter merely referred to as a substrate) 6. The thermal medium is not limited to a specific material. The thermal medium is appropriately selected from water, oil, or coolant in general. The thermal medium uniformly flows, whereby the heat can efficiently be transferred to one surface of the thermoelectric conversion module 5.

In the airtight container 13 of the present embodiment, the whole region of the lower case 12 is not specified as the thermal medium circulating chamber 14, but the electrode groove 22 for leading out the electrode and arranging the same is formed at one side, wherein the electrode groove 22 communicates with the space above the partition plate 7 to constitute a part of the thermoelectric conversion module storing chamber 17. In the present embodiment, the lower case 12 is configured such that a thin plate made of a material having excellent coexistent property with the thermal medium is molded into the illustrated shape with spinning by a pressing. It is preferable that a material having excellent coexistent property with the cooling or the heating fluid is used as the material of the partition plate 7 serving as a cooling or a heating panel and inlet and outlet pipes 19a and 19b. For example, stainless steel is suitable for water.

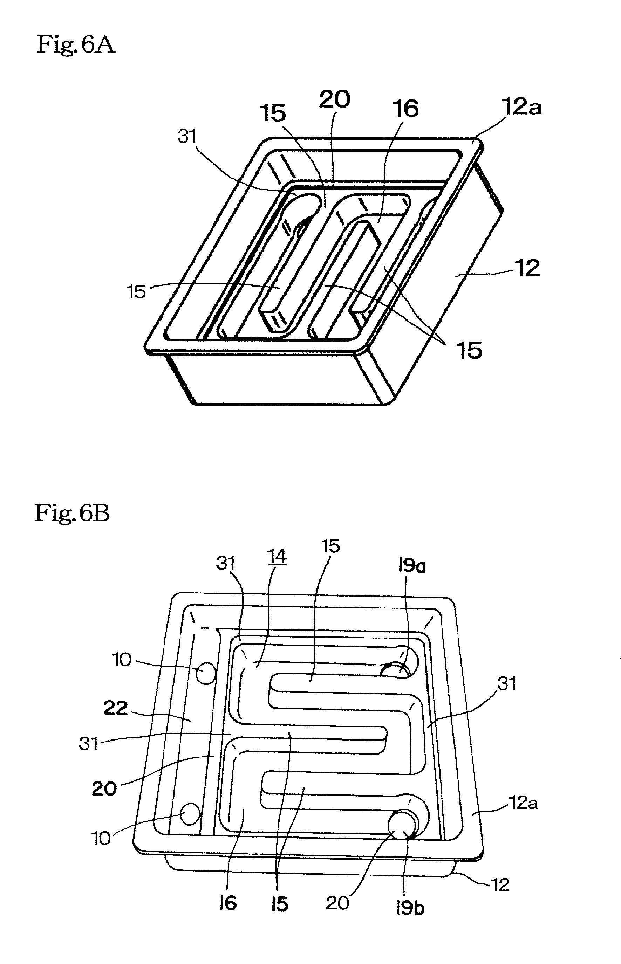

As illustrated in FIGS. 6(A) and 6(B), the flow path 16 for flowing the thermal medium is a single heavily winding groove that rises toward the partition plate 7 from the bottom surface of the lower case 12 and formed by the plural partition walls 15 alternately projecting from one side to the other side of the opposing gate. The inlet pipe 19a and the outlet pipe 19b serving as the inlet and outlet of the thermal medium are formed at both ends respectively. The inlet pipe 19a and the outlet pipe 19b of the thermal medium are formed from a pipe bonded to a hole 29, which is open at the bottom surface of the lower case 12, with brazing or welding so as to be connected to an unillustrated external thermal medium supplying source. Thus, the thermal medium circulating chamber 14 is formed with the flow path 16 that circulates the thermal medium, supplied from the external thermal medium supplying source (not illustrated), between the external thermal medium supplying source and the thermal medium circulating chamber 14, whereby heat is transferred to or received from one surface of the thermoelectric semiconductor 2 via the partition plate 7 with the thermal medium circulating in the flow path 16.

The thermoelectric conversion module 5 may be supported by the substrate 6 having electrical insulating property. The substrate 6 is a metallic plate, for example, and the electrode 4 is bonded with an insulating bonding member. In this case, the partition plate 7 and the substrate 6 are brought into intimate contact with each other by a bonding with the use of an adhesive agent or brazing filler metal, or by applying a thermal-conductive grease. A ceramic substrate having the electrode 4 vapor-deposited thereon can be used, instead of the metallic substrate 6 and the electrode 4. Since the substrate 6 is configured by using the ceramic having electrical insulating property, an electrical insulating bonding member is unnecessary between the substrate 6 and the electrode 4. A product formed by vapor-depositing copper on an alumina plate in the form of an electrode is available as DBC (Direct Bonding Copper), and this can be used as the substrate 6 and the electrode 4. In this case, the partition plate 7 and the substrate 6 are bonded to be brought into intimate contact with each other with a bonding or brazing, for example. In this case, the ceramic substrate 6 can serve as the partition plate 7, and this may be bonded to the case 20 with a metal/ceramic bonding agent.

A two-sided skeleton module (not illustrated) having no substrate on upper and lower surfaces can be employed for the thermoelectric conversion module 5. In this case, the electrode 4 is exposed. Therefore, it is necessary to insert a thin sheet having electrical insulating property and heat resistance such as a mica sheet or a polymer sheet into the upper and lower surfaces of the module so as to establish electrical insulation. In this case, the thermal-conductive grease is applied on one surface or both surfaces of the sheet having electrical insulating property and heat resistance to establish an intimate contact, whereby the thermal contact resistance can be reduced.

It is preferable that a sliding member 30 having thermal conductivity is interposed between the surface of the upper case 11, opposing to the thermoelectric conversion module 5, in the packaged thermoelectric conversion system 1 and the electrode plate 3. Due to the presence of the thermal-conductive sliding member 30, the thermal connection is achieved between the upper case 11 and the electrode 3, and the relative sliding movement, i.e., the shift movement, between the upper case 11 and the electrode 3 is easily generated. The sliding member 30 has at least thermal conductivity and sliding property (sliding), and more preferably has insulating electrical property. However, if an electrical insulating member or an electrical insulating layer is interposed between the electrode portion 3 and the sliding member 30, the sliding member 30 does not have to have electrical insulating property. In view of this, a sheet material having thermal conductivity and low friction coefficient or a viscous material such as grease is preferable for the sliding member 30. Specifically, a carbon sheet or polymer sheet is preferably used as the sheet material. The carbon sheet is excellent in sliding property, and further, excellent in thermal conductivity and heat resistance. Therefore, the thermoelectric semiconductor having higher maximum operating temperature can be used by the use of the carbon sheet, and the thermal resistance at the interface where the carbon sheet is present can be reduced by a factor of 10 or less compared to the case in which the carbon sheet is not present. Further, the electrical insulation is secured with the use of the carbon sheet together with the mica sheet, and thermal conductivity and sliding movement at the interface can be made satisfactory. When the thermoelectric conversion module is used as being contained in the airtight container, in particular, it can be used at higher temperature than the case in which it is used in atmosphere. The polymer sheet is excellent in sliding property and has electrical insulating property, so that it can directly be brought into contact with the electrode material. When the grease that is the viscous material is applied between the upper case 11 and the electrode 3 as the sliding member, the generation of shearing stress is prevented, and the heating plate and the electrode portion are brought into intimate contact with each other without forming a gap because the grease is the viscous material, whereby the thermal contact resistance at the interface can be reduced. Accordingly, a great temperature difference can be applied to the thermoelectric semiconductor. Further, it is sealed in the airtight container, whereby there is no problem of the deterioration of the grease or evaporation of the grease due to the thermal oxidation. Therefore, the grease can stably be retained between the container and the heat-source-side electrode portion for a long period.

According to the packaged thermoelectric conversion module thus configured, the airtight container 13 externally receives pressing force due to the differential pressure between the inside and the outside of the container. The surface, opposing to the thermoelectric conversion module 5, of the upper case 11 of the airtight container 13 is uniformly pressed against the thermoelectric conversion module 5 with this pressing force. Therefore, the heat received by the upper case 11 of the airtight container is uniformly transferred to or received from the thermoelectric conversion module 5. On the other hand, the heat of the thermal medium flowing through the flow path 16 in the airtight container 13 is efficiently transferred to the lower surface of the thermoelectric conversion module 5 via the partition plate 7 and the substrate 6, Therefore, the temperature difference is appropriately applied to the thermoelectric conversion module 5 without applying external force to the packaged thermoelectric conversion module 1 by using a pressing mechanism.

When the sliding member 30 is provided between the upper case 11 of the airtight container 13 and the electrode 3, the upper case 11 of the airtight container 13 is allowed to slide in the plane direction on the sliding member 30 even if, for example, the airtight container 13 thermally expands. Therefore, large shearing force is not exerted to the thermoelectric semiconductor 2 and the electrodes 3 and 4. Accordingly, even if the size of the packaged thermoelectric conversion module 1 is increased, neither the weak thermoelectric semiconductor 2 is destroyed, nor the peeling is caused on the bonding surface. Since the interface where the sheet material or the grease is present is pressed from the outside of the airtight container 13 due to the differential pressure between the inside and the outside of the airtight container 13, the thermal contact resistance at the interface can be reduced because of the satisfactory adhesion. Thus, a large temperature difference can be applied to the thermoelectric semiconductor 2.

Since the thermal expansion of the constituent members is allowed as described above, the size of the thermoelectric conversion module 1 can be increased. Accordingly, the substantial packing density of the thermoelectric semiconductors 2 can be enhanced, whereby the output density (output per unit area) can be increased. Since the components of the thermoelectric conversion module 1 are stored in the airtight container 13, the strength to the external force is increased. Since the components of the thermoelectric conversion module 1 are sealed in the airtight container 13, the thermoelectric conversion module 1 can directly be placed and used even in any atmosphere, e.g., even under the oxidation atmosphere or corrosive atmosphere.

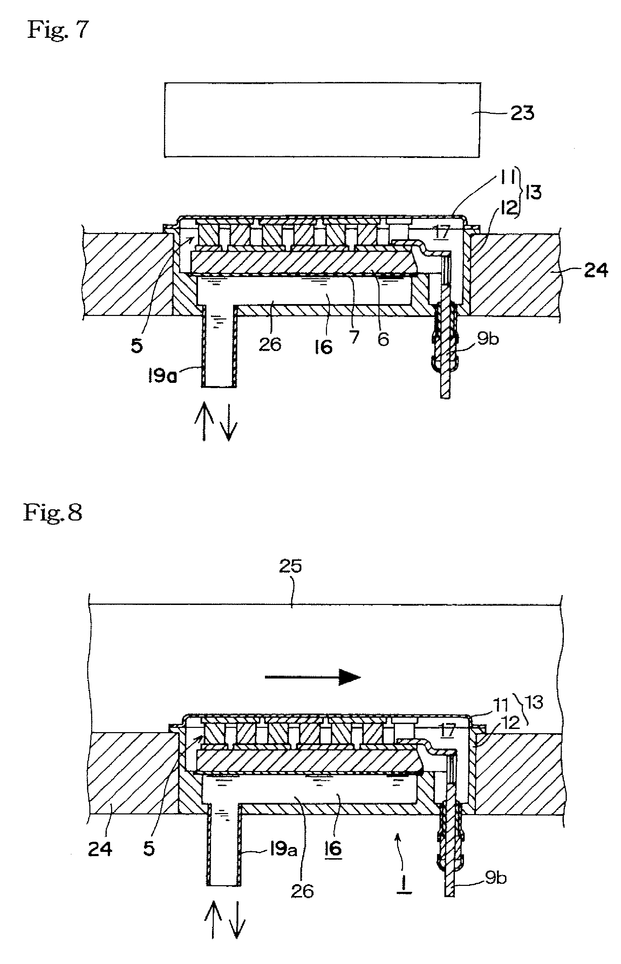

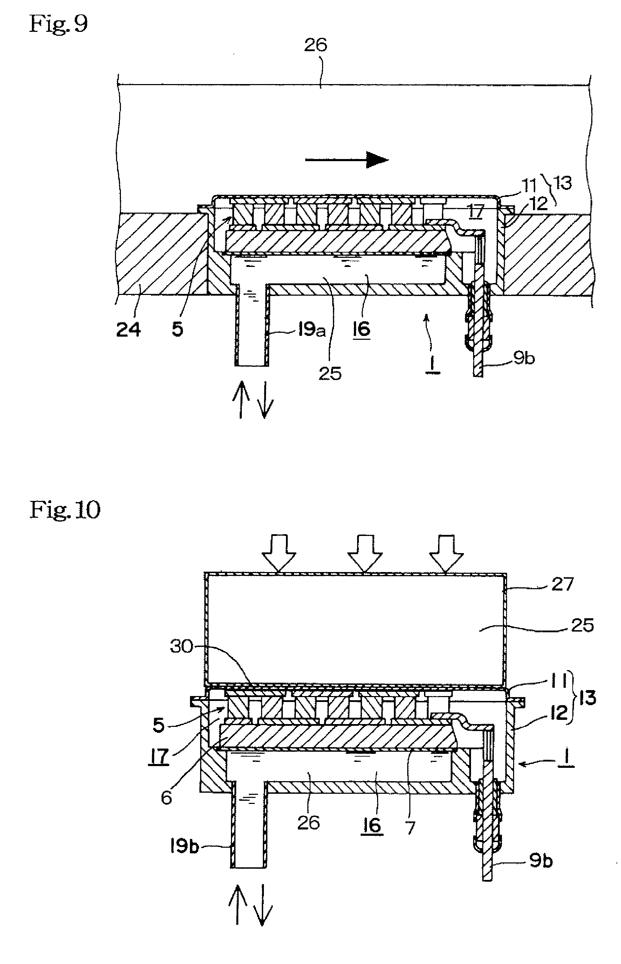

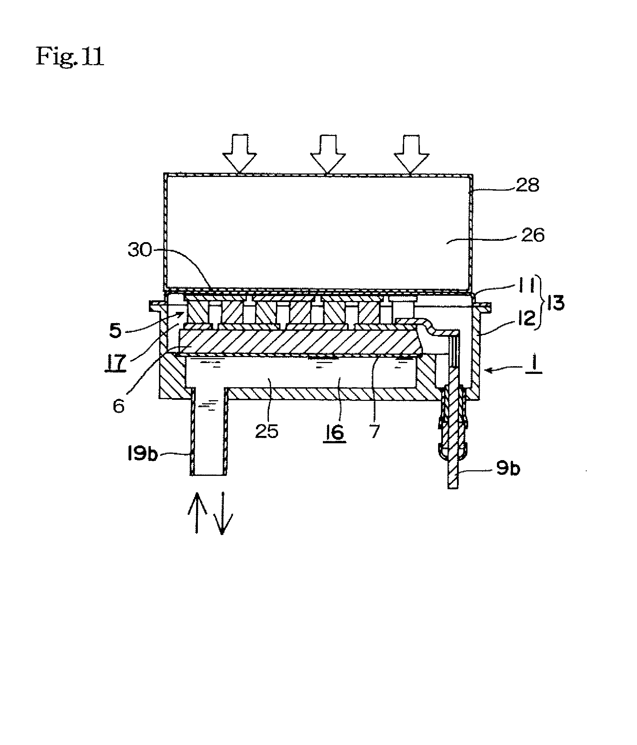

The packaged thermoelectric conversion module 1 having the above-mentioned configuration can be used for various purposes. For example, as illustrated in FIG. 7, the cooling fluid 26 can be circulated in the flow path 16 in the airtight container 13, while the outside of the top surface (the surface with which the upper part of the thermoelectric conversion module 5 is in contact) of the upper case 11 can be heated by a radiant heat source 23. In this case, it is preferable that the lower case 12 of the airtight container 13 is enclosed by a heat insulating material 24, and only the upper case 11 is arranged to be exposed to the radiant heat source 23, As illustrated in FIG. 8, the cooling fluid 26 can be circulated in the flow path 16 in the airtight container 13, while a heating fluid 25 can be flown around the upper case 11 and at the outside of the upper case 11 in order to generate electricity. As illustrated in FIG. 9, the cooling fluid 25 can be circulated in the flow path 16 in the airtight container 13, and the cooling fluid 26 is flown around the upper case 11 and at the outside of the upper case 11 in order to generate electricity. As illustrated in FIG. 10, the cooling fluid 26 can be circulated in the flow path 16 in the airtight container 13, and a heating duct 27 is in pressed contact with the surrounding and the outside of the upper case 11 so as to flow the heating fluid 25 in the heating duct 27 for heating. As illustrated in FIG. 11, the heating fluid 25 can be circulated in the flow path 16 in the airtight container 13, and a cooling duct 28 is in pressed contact with the surrounding and the outside of the upper case 11 so as to flow the cooling fluid 26 in the cooling duct 28 for cooling. In the examples illustrated in FIGS. 10 and 11, the packaged thermoelectric conversion module 1 and the heating duct 27 or the cooling duct 28 have to be brought into pressed contact with each other. However, the pressing mechanism is simplified, compared to a system of applying pressure with the packaged thermoelectric conversion module 1 being sandwiched between the heating duct 27 and the cooling duct 28, like the conventional thermoelectric conversion system. On the other hand, in the examples illustrated in FIGS. 7 to 9, one surface of the thermoelectric semiconductor 2 is heated or cooled by radiation heat transfer from the radiant heat source 23 opposite to the upper case 11 of the packaged thermoelectric conversion module 1 or by convected heat transfer from the thermal medium flowing through the surrounding of the upper case 11 of the packaged thermoelectric conversion module 1, and the other surface of the thermoelectric semiconductor 2 is cooled or heated by the cooling fluid or the heating fluid flowing through the flow path 16 in the airtight container 13 via the partition plate 7, whereby a mechanism for attaining a pressed contact is not needed. As described above, the packaged thermoelectric conversion module 1 is configured such that the cooling fluid 26 or the heating fluid 25 is flown through the airtight container 13, whereby the packaged thermoelectric conversion module 1 can be used under any environment only by arranging the packaged thermoelectric conversion module 1.

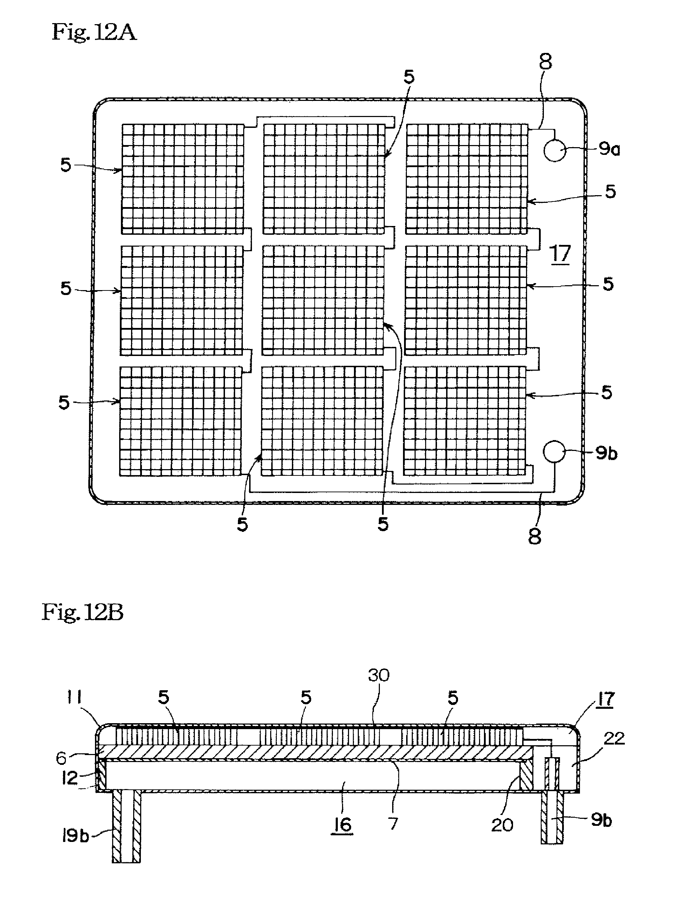

Plural thermoelectric conversion modules 5 can be contained in the airtight container 13. For example, as illustrated in FIGS. 12(A) and (B), nine thermoelectric conversion modules 5 may be contained, each of which are connected in series. The size of one side of one thermoelectric conversion module 5 is about 4 cm, and the size of one side of even the greatest one is about 6 cm. When, for example, nine thermoelectric conversion modules are collectively contained in a single airtight container 13, the cost of the airtight container itself is not increased nine-fold, so that it gets much cheaper. Therefore, a unit cost for facility per output of the module can be reduced. Since the respective modules can be closely aligned, the module arrangement density per unit area can be increased, compared to the case in which a single module is contained in the airtight container 13.

EXAMPLE

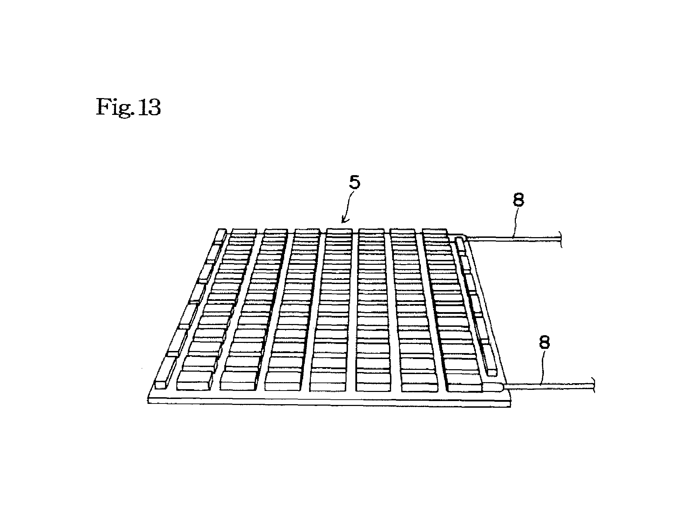

The performance of the packaged thermoelectric conversion module according to the present invention was compared to that of an exposed thermoelectric conversion module which was not contained in the airtight container as illustrated in FIG. 13. The components of the packaged thermoelectric conversion module and the thermoelectric conversion module are identified by the same numerals, and the detailed description will be skipped.

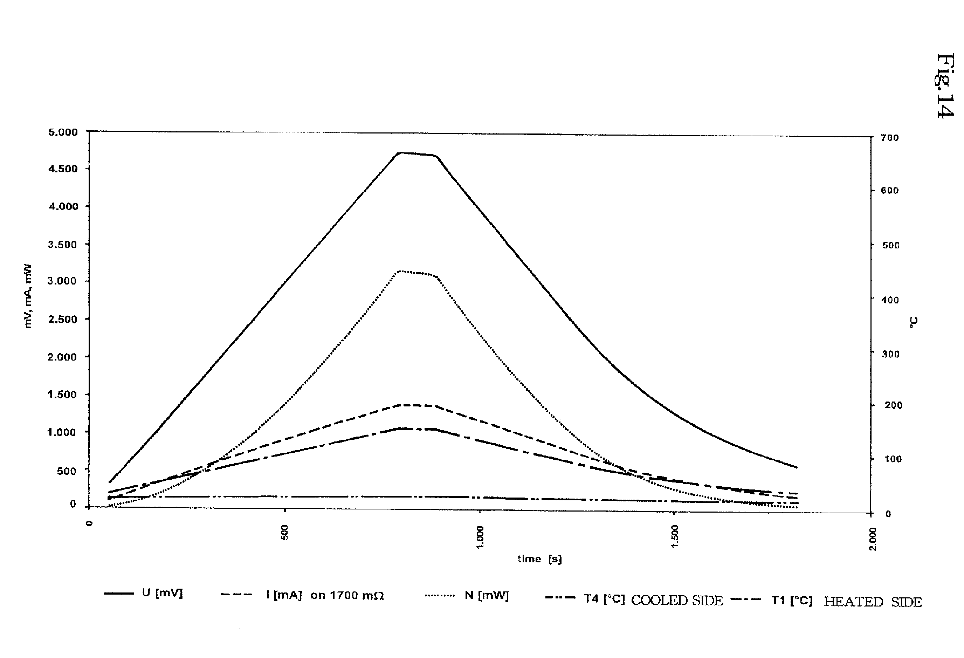

Firstly, a low-temperature thermoelectric conversion modules 5 was prepared by using BiTe of 4 x 4 mm as the thermoelectric semiconductor 2. The output was measured when a temperature of 150 °C was applied to the high-temperature side of the module, a temperature of 20°C was applied to the low-temperature side, and a temperature difference of 130 K was applied. FIG. 14 illustrates the result. It was confirmed from the result that the output of 3.2 W was obtained.

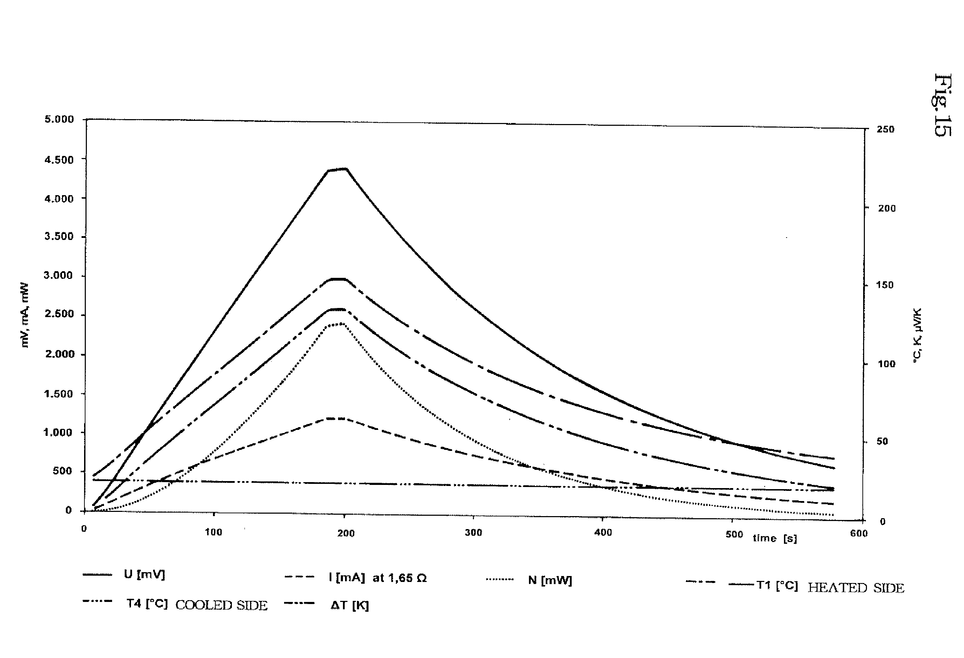

Next, the thermoelectric conversion modules having the configuration illustrated in FIG. 13 were contained in the airtight container 13 so as to form a low-temperature packaged thermoelectric conversion module 1 having a sealed structure illustrated in FIG. 12. The high-temperature side of the airtight container 13 was kept to be 150°C, and when cooling water of 20°C is flown, at a flow rate of about 1 g/s, into the flow path 16 for flowing the thermal medium in the container, the output was measured. FIG. 15 illustrates the result. The outlet temperature of the cooling water was about 25°C, and it was confirmed from the result that the output of 2.4 W was obtained. The output is lower than that of the comparative example illustrated in FIG. 14 by 25%, but this is caused by the thermal resistance of the upper case 11 and the partition plate 7, and this is a reasonable tendency. From the above, it can be said that the performance equal to or higher than the performance of the conventional module having the pressing mechanism for reducing thermal contact resistance or having the thermal-conductive grease applied between the heating duct or the cooling duct can be obtained. It is further considered that this performance can be maintained for a long period without providing the pressing mechanism or requiring the re-application of the thermal-conductive grease.

When water is used as the cooling fluid 26, the necessary flow rate when the inlet temperature of water is 25°C, and the outlet temperature is 45°C can be obtained according to the procedures described below. It is to be noted that, when the conversion efficiency of the thermoelectric conversion module is defined as 10%, and the output per one module is defined as 10 W, the heat quantity that should be removed by the cooling water is 90 W.

$$P = WCp\Delta T$$

wherein,
P: Heat quantity that should be removed by cooling water (= 90 W = 0.09 W)

W: Flow rate of water (kg/s)
Cp: Specific heat of water (= 4.2 kWs/kgK)
ΔT: Temperature difference between inlet and outlet of water (= 20 K)

$$W = P/(Cp\Delta T) = 0.09/(4.2 \times 20) = 0.0011 \ (\text{kg/s}) = 1.1 \ (\text{g/s})$$

The flow velocity of water in the cooling panel, i.e., in the flow path 16 below the partition plate 7, is calculated by the equation described below. When the width of the flow path 16 below the partition plate 7 is defined as 7 mm, and the height of the flow path is defined as 5 mm, the sectional area of the flow path is 0.35 cm$^2$, Therefore,

$$V = Q/A = 1.1/0.35 = 3.1 \ (\text{cm/s})$$

Wherein
V: Flow velocity of cooling water (cm/s)
Q: Flow rate of cooling water (=1.1 cm$^3$/s)
A: Sectional area of flow path (= 0.35 cm$^2$)
If the flow velocity is 3.1 (cm/s), the fluid pressure loss is very small, so that it is no problem.

The above-mentioned embodiment is one example of preferred embodiments of the present invention, and the present invention is not limited thereto, but various modifications are possible without departing form the scope of the present invention. For example, one or both of the electrodes 9a and 9b and the inlet and outlet pipes 19a and 19b of the thermal medium can be provided at the side face, not the bottom surface, of the lower case 12. When the electrodes 9a and 9b are provided at the side face of the lower case 12, the whole lower case 12 is divided into two layers by the partition plate 7, wherein the thermoelectric conversion module storing chamber 17 having the thermoelectric conversion module 5 and the electrodes 9a and 9b placed herein is formed on the layer above the partition plate 7, while the flow path 16 into which the thermal medium for cooling or heating is flown can be formed on the whole layer below the partition plate 7.

INDUSTRIAL APPLICABILITY

The present invention is applicable to a thermoelectric conversion module that is heated by a radiation from a high-temperature heat source, for example, a thermoelectric conversion module that generates electricity by utilizing waste heat radiated from a heated component at the inside or outside of an industrial furnace such as a powdered metallic ceramic sintering furnace or various electric furnaces, a thermoelectric conversion module that generates electricity by utilizing waste heat from waste gas or high-temperature fluid such as waste liquid discharged from various industrial facilities utilizing heat or involved with heat, such as an industrial waste sintering furnace, with a convection heat transfer, or a thermoelectric conversion module that generates electricity by heating or cooling through the contact to a solid heating source or cooling source. Therefore, the packaged thermoelectric conversion module can be used only by arranging the same under any environment.

EXPLANATION OF NUMERALS

| | |
|---|---|
| 1 | Packaged thermoelectric conversion module |
| 2 | Thermoelectric semiconductor |
| 3 | One electrode |
| 4 | Other electrode |
| 5 | Thermoelectric conversion module |
| 6 | Thermoelectric conversion module substrate |
| 7 | Partition plate (thermal-conductive panel) |
| 9a, 9b | Electrode |
| 11 | Upper case |
| 12 | Lower case |
| 13 | Airtight container |

| 14 | Thermal medium circulating chamber |
| 16 | Flow path in which thermal medium circulates |
| 17 | Thermoelectric conversion module storing chamber |
| 19a, 19b | Inlet and outlet of thermal medium connected to unillustrated thermal medium supplying source (pipe) |

**Claims**

1. A packaged thermoelectric conversion module in which an interior of an airtight container containing a thermoelectric conversion module is decompressed or evacuated, wherein the interior of the airtight container is partitioned into at least two chambers by a partition plate, wherein one chamber is provided with the thermoelectric conversion module and an electrode led out to the outside of the airtight container, while the other chamber is provided with a flow path for introducing a thermal medium from an external thermal medium supplying source and circulating the thermal medium between the chamber and the external thermal medium supply source, and heat is transferred to or received from one surface of the thermoelectric semiconductor by the thermal medium via the partition plate, while heat is transferred or received between the other surface of the thermoelectric semiconductor and an external heat source via the airtight container.

2. The packaged thermoelectric conversion module according to claim 1, wherein at least the surface of the airtight container that is in contact with the other surface of the thermoelectric semiconductor is made of a thermal-conductive material having flexibility.

3. The packaged thermoelectric conversion module according to claim 1, wherein the airtight container includes an upper case and a lower case, wherein the thermal medium circulating chamber is formed by a gate provided at the bottom part of the lower case, while the partition plate is fitted to be bonded to a striker plate formed on the top surface of the gate enclosing the thermal medium circulating chamber so as to form a liquid-tight flow path between the partition plate and the lower case.

4. The packaged thermoelectric conversion module according to claim 3, wherein the flow path is a single heavily winding groove that rises from the bottom surface of the lower case toward the partition plate, and that is formed by plural partition walls alternately projecting from one side to the other side of the opposing gate, wherein an inlet pipe and an outlet pipe serving as an inlet and an outlet of the thermal medium are connected to both ends of the flow path, respectively,

5. The packaged thermoelectric conversion module according to claim 1, wherein the thermoelectric conversion module is supported by a thermoelectric conversion module substrate having electrical insulating property, and is mounted on the partition plate via the substrate.

6. The packaged thermoelectric conversion module according to claim 1, wherein the thermoelectric conversion module is a two-sided skeleton module having no substrate on upper and lower surfaces.

7. The packaged thermoelectric conversion module according to claim 1, wherein the thermal medium is a cooling fluid.

8. The packaged thermoelectric conversion module according to claim 1, wherein the thermal medium is a heating fluid.

Fig.1

EP 2 383 809 A1

Fig.2

Fig.3

13

Fig. 4

Fig. 5

Fig.6A

Fig.6B

Fig. 7

Fig. 8

Fig.9

Fig.10

Fig.11

Fig. 12A

Fig. 12B

Fig.13

Fig.14

Fig.15

<table>
<tr><td colspan="2">**INTERNATIONAL SEARCH REPORT**</td><td>International application No.<br>PCT/JP2010/000185</td></tr>
</table>

A.  CLASSIFICATION OF SUBJECT MATTER
*H01L35/30*(2006.01)i, *H02N11/00*(2006.01)i

According to International Patent Classification (IPC) or to both national classification and IPC

B.  FIELDS SEARCHED

Minimum documentation searched (classification system followed by classification symbols)
H01L35/30, H02N11/00

Documentation searched other than minimum documentation to the extent that such documents are included in the fields searched
Jitsuyo Shinan Koho          1922-1996   Jitsuyo Shinan Toroku Koho   1996-2010
Kokai Jitsuyo Shinan Koho    1971-2010   Toroku Jitsuyo Shinan Koho   1994-2010

Electronic data base consulted during the international search (name of data base and, where practicable, search terms used)

C.  DOCUMENTS CONSIDERED TO BE RELEVANT

| Category* | Citation of document, with indication, where appropriate, of the relevant passages | Relevant to claim No. |
|---|---|---|
| A | JP 2006-049872 A  (Central Research Institute of Electric Power Industry), 16 February 2006 (16.02.2006), fig. 1 to 15 & US 2006/0005873 A1   & EP 1615274 A2 | 1-8 |
| A | JP 2006-066431 A  (Toshiba Corp.), 09 March 2006 (09.03.2006), fig. 1 to 12 (Family: none) | 1-8 |
| A | JP 2007-311656 A  (Toyota Motor Corp.), 29 November 2007 (29.11.2007), fig. 1 to 8 (Family: none) | 1-8 |

☒  Further documents are listed in the continuation of Box C.    ☐  See patent family annex.

\*   Special categories of cited documents:
"A"  document defining the general state of the art which is not considered to be of particular relevance
"E"  earlier application or patent but published on or after the international filing date
"L"  document which may throw doubts on priority claim(s) or which is cited to establish the publication date of another citation or other special reason (as specified)
"O"  document referring to an oral disclosure, use, exhibition or other means
"P"  document published prior to the international filing date but later than the priority date claimed

"T"  later document published after the international filing date or priority date and not in conflict with the application but cited to understand the principle or theory underlying the invention
"X"  document of particular relevance; the claimed invention cannot be considered novel or cannot be considered to involve an inventive step when the document is taken alone
"Y"  document of particular relevance; the claimed invention cannot be considered to involve an inventive step when the document is combined with one or more other such documents, such combination being obvious to a person skilled in the art
"&"  document member of the same patent family

Date of the actual completion of the international search
02 April, 2010 (02.04.10)

Date of mailing of the international search report
13 April, 2010 (13.04.10)

Name and mailing address of the ISA/
Japanese Patent Office

Authorized officer

Facsimile No.

Telephone No.

Form PCT/ISA/210 (second sheet) (July 2009)

**INTERNATIONAL SEARCH REPORT**

International application No.

PCT/JP2010/000185

C (Continuation).   DOCUMENTS CONSIDERED TO BE RELEVANT

| Category* | Citation of document, with indication, where appropriate, of the relevant passages | Relevant to claim No. |
|---|---|---|
| A | JP 2002-100816 A  (Matsushita Refrigeration Co.), 05 April 2002 (05.04.2002), fig. 7 (Family: none) | 1-8 |
| A | JP 09-018059 A  (Technova Inc.), 17 January 1997 (17.01.1997), fig. 1 to 20 (Family: none) | 1-8 |

Form PCT/ISA/210 (continuation of second sheet) (July 2009)

**EP 2 383 809 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2006049872 A